# EUROPEAN PATENT APPLICATION

(11) **EP 3 082 158 A1**
(43) Date of publication of application: **19.10.2016**
(21) Application number: 15163907.7
(22) Date of filing: 16.04.2015
(51) Int. Cl.: H01L 23/40

(54) **PRESSING DEVICE FOR PRESSING A COMPONENT AGAINST AN ELEMENT**

(71) Applicant: Valeo Powertrain Energy Conversion AS, 3036 Drammen (NO)
(72) Inventor: SPANGBERG, Erik, 32 3038 Drammen (NO)
(74) Representative: Tran, Chi-Hai

(57) **Abstract**

The invention relates to a pressing device (10) of an element (12) for pressing a component (16) against the element, the element (12) comprises a top wall (24) and a side wall (26) extending perpendicular to the top wall, the pressing device (10) comprising a spring clip (30), a top retaining element (32) and a side retaining element (34), wherein the top retaining element and the side retaining element are arranged respectively on the top wall and on the side wall and configured respectively to cooperate with a first and a second complementary retaining elements (44, 46) arranged on the spring clip (30), and wherein the spring clip is configured to exert a force to press the component against the side wall of the element in a lock position when the component is positioned against the element.

## Description

The invention relates to a pressing device of an element for pressing a component against the element and to a method for pressing the component against the element thanks to such pressing device.

More particularly, the invention relates to the field of pressing device configured to press a component against an element. Advantageously, such pressing devices are often used in the electronics field and specifically for electronic devices used for power applications.

Indeed, in power applications, a heatsink is often used to remove continuously heat from the electronic devices, which need to be cooled because they do not perform well at elevated temperature. In order to remove heat from the electronic device in an efficient way, so as to keep the temperature thereof at safe levels, the electronic device should be attached to the heatsink in such a way that a sufficiently large surface portion of an insulating body of the electronic device is in direct contact with the heatsink itself.

According to a solution known in the art, a package of the electronic device is configured to be fastened to the heatsink by means of an insertable fastener, such as for example a screw, a rivet, configured to go through the insulating body.

Nevertheless, the use of such insertable fasteners increases the risk of assembly defects and the material cost of manufacturing contact assemblies, as well as the labor cost.

Therefore, there is a need for providing a reliable pressing device of an element for pressing a component against the element which can be easily assembled.

To this end, the invention proposes a pressing device of an element for pressing a component against the element, the element comprises a top wall and a side wall extending perpendicular to the top wall, the pressing device comprising a spring clip, a top retaining element and a side retaining element, wherein the top retaining element and the side retaining element are arranged respectively on the top wall and on the side wall and configured respectively to cooperate with a first and a second complementary retaining elements arranged on the spring clip, and wherein the spring clip is configured to exert a force to press the component against the side wall of the element in a lock position when the component is positioned against the element.

Advantageously, thanks to such pressing device a pressure force is applied on the component to the element, taking account for mechanical tolerances and thermal variations. A correct pressure is obtained and assembly time in production is reduced. Furthermore, the pressing device according to the invention is also reliable in case of vibrations.

When using screws, one has to check multiple parameters (torque, the speed of the screwing...) and screws can come loose because of vibrations during the life time of the product (that is the threading of the screw is not sharp anymore, therefore the fixation property is lost). The mounting operation of the invention is faster, easier and allows to obtain a pressing having more resistance with respect to vibrations.

Moreover, the pressing device can be used to press several components against the element at one time in order to have an efficient assembly process for mass production.

The pressing device according to the invention allows to obtain a compact assembly of the element and the component.

According to further embodiments which can be considered alone or in combination:
- the spring clip comprises a proximal end and a distal end, the first complementary retaining element is arranged on the proximal end and the second complementary retaining element is arranged between the proximal end and the distal end and wherein the distal end is configured to exert the force on the component when the spring clip presses the component against the side wall of the element;
- at least one of the top retaining element and the side retaining element comprises a protrusion extending from the wall comprising the at least one of the top and the side retaining elements and the complementary retaining element configured to cooperate with the at least one of the top and the side retaining elements comprises an aperture configured to cooperate with the protrusion;

- the first complementary retaining element at the proximal end of the spring clip comprises a lip and the top retaining element comprises a groove arranged on the top wall and configured to cooperate with the lip at the proximal end of the spring clip;
- the second complementary retaining element of the spring clip comprises a resilient lip adapted to cooperate with the side retaining element;
- the spring clip comprises a first part and a second part on which is arranged respectively the first and the second complementary retaining elements, the first part and the second part forming a first angle less than or equal to 90° in a rest position wherein the component is not pressed;
- the second part forms a resilient strip extending according to a reference plane;
- the side retaining element comprises an abutment extending perpendicular to the side wall;
- the second complementary retaining element comprises an opening having a V-shape configured to form a receptacle for the abutment and a resilient lip extending from the distal end and having a complementary V-Shape, the resilient lip being configured to cooperate with the abutment in the lock position;
- the pressing device is for pressing an electronic component;
- the element comprises a heatsink;
- the pressing device further comprises a plate parallel to the side wall and arranged between the component and the spring clip in the lock position.

Another object of the invention relates to an assembly for at least one component comprising an element and a pressing device for pressing each of the at least one component against the element as described hereinbefore according to the invention. Particularly, the invention relates to a heatsink assembly for one or several electronic components comprising a heatsink and a pressing device as described hereinbefore according to the invention for pressing each of the at least one electronic component against the heatsink.

Another object of the invention relates to a method for pressing a component against an element comprising a pressing device according to the invention, the method comprising the steps of:
- providing the element and the pressing device comprising the spring clip;
- providing the component and positioning the component against the side wall of the element;
- engaging the first complementary retaining element with the top retaining element on the top wall to a position in which the second complementary retaining element cooperates with the side retaining element and the spring clip presses the component against the side wall of the element in a lock position.

Non limiting embodiments of the invention will now be described, by way of example only, and with reference to the following drawings in which:
- Figure 1 is a schematic representation of a pressing device according to an embodiment of the invention in use for pressing a component against an element;
- Figure 2 is perspective view of the spring clip of the pressing device of figure 1;
- Figure 3 is a detailed view of retaining elements and complementary retaining elements of the pressing device of figure 1; and
- Figure 4 illustrates another embodiment of a first retaining element and a first complementary retaining element of a pressing device according to the invention.

Elements in the figures are illustrated for simplicity and clarity and have not necessarily been drawn to scale. For example, the dimensions of some of the elements in the figure may be exaggerated relative to other elements to help improve the understanding of the embodiments of the present invention.

Certain terminology will be used in the following description for convenience in reference only and will not be limiting. For example, top, bottom, front, back, right and left refer to the invention in relation as orientated in the figures being referred to.

The invention relates to a pressing device of an element for pressing a component against the element.

Advantageously, the pressing device is configured for pressing simultaneously several components and preferably two or three components, against the element.

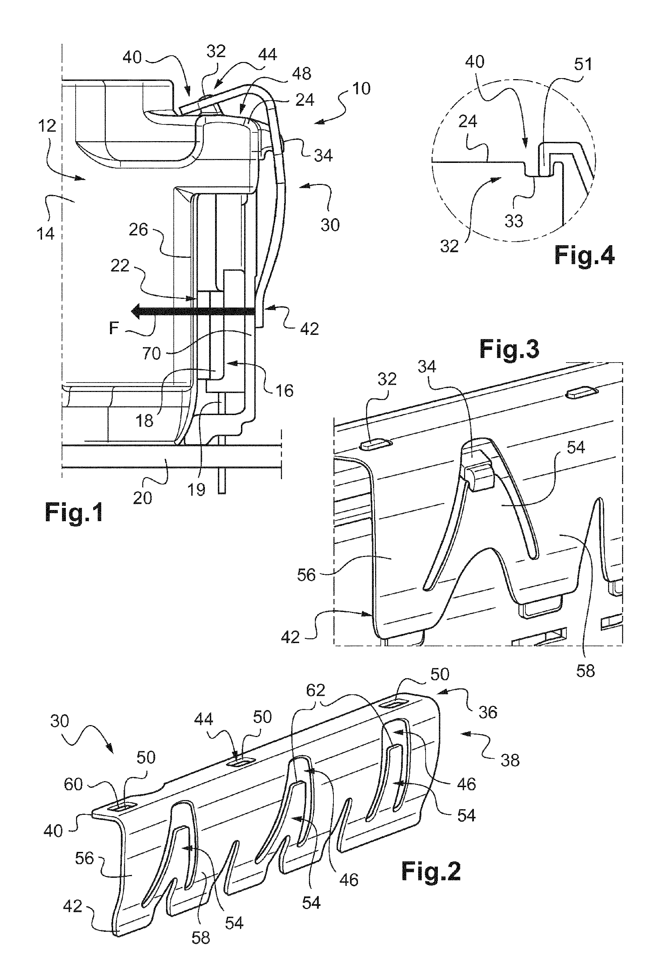

Figure 1 illustrates an embodiment of a pressing device 10 according to the invention wherein the element 12 is a heatsink 14 and the component 16 is an electronic component 18 for example used in power applications. The heatsink 14 is configured to remove continuously heat produced by the electronic component 18 during use.

The electronic component 18 typically comprises a chip, for example a power component, on which electronic circuits are integrated and a package in which the chip is embedded for protecting it. The package comprises an insulating body having exposed leads which are electronically connected to the chip and configured to be connected to external circuits. To this end, the electronic component is usually fixedly mounted on a support 20, typically a printed circuit board (PCB), for example through electrical pins 19.

The insulating body has a substantially flat back surface 22 which is configured to contact a surface of the heatsink when the electronic component is mounted on the PCB for removing heat produced during operation of the electronic component.

The element 12, here the heatsink 14, comprises a top wall 24 and a side wall 26 extending perpendicular to the top wall 24. The side wall 26 is configured to contact the back surface 22 of the electronic component 18 when the electronic component is pressed against the element 12.

The pressing device 10 comprising a spring clip 30, a top retaining element 32 and a side retaining element 34.

The top retaining element 32 and the side retaining element 34 are arranged respectively on the top wall 24 and on the side wall 26 of the element 12.

The spring clip 30 is configured to exert a force to press the component 16 against the side wall 26 of the element 12 in a lock position when the component 16 is positioned against the element 12. Preferably, the force is according to a transverse direction, for example substantially perpendicular to the side wall as illustrated by the arrow F.

With reference to figures 2 to 4, the spring clip 30 comprises a first part 36 and a second part 38 interconnected one with the other such that the first part 36 and the second part 38 form a first angle less than or equal to 90° in a rest position wherein the component 16 is not pressed against the element 12.

Furthermore, the spring clip 30 comprises a proximal end 40 and a distal end 42 opposed to the proximal end, each extending from the free ends of respectively the first part 36 and the second part 38 of the spring clip 30. The distal end 42 is configured to exert the force on the component 16 when the spring clip 30 presses the component 16 against the side wall 26 of the element 12.

Moreover, the spring clip 30 comprises a first complementary retaining element 44 arranged on the proximal end 40 of the first part 36 and a second complementary retaining element 46 arranged on the second part 38 between the proximal end 40 and the distal end 42.

The top retaining element 32 and the side retaining element 34 are configured respectively to cooperate with the first and second complementary retaining elements 44, 46 arranged on the spring clip 30.

At least one of the top retaining element 32 and the side retaining element 34 comprises a protrusion extending from the wall comprising the at least one of the top and the side retaining elements and the complementary retaining element configured to cooperate with the at least one of the top and the side retaining elements comprises an aperture configured to cooperate with the protrusion.

In a preferred embodiment illustrated on figure 1, the top retaining element 32 comprises a protrusion extending from a top wall portion 48 comprising the top retaining element 32. The first complementary retaining element 44 configured to cooperate with the top retaining element 32 comprises an aperture 50 configured to cooperate with the protrusion. The protrusion integrated in the heatsink allows keeping the spring clip in position.

According to a variant illustrated on figure 4, the first complementary retaining element 44 at the proximal end 40 of the spring clip comprises a lip 51 and the top retaining element 32 comprises a groove 33 arranged on the top wall 24 and configured to cooperate with the lip at the proximal end of the spring clip.

Furthermore, according to the preferred embodiment illustrated on figure 1, the side retaining element 34 further comprises a protrusion forming an abutment extending perpendicular to the side wall 26 from a wall portion of the side wall comprising the side retaining element 34. Moreover, the second complementary retaining element 46 configured to cooperate with the side retaining element comprises an opening 46 and a resilient lip 54 adapted to cooperate with the side retaining element 34.

Advantageously, the second part 38 of the spring clip forms a resilient strip extending according to a reference plane and the opening 52 has a V-shape configured to form a receptacle for the abutment. The resilient lip 54 is formed from the opening 52 by extending from the distal end 42 and having a complementary V-Shape to be configured to cooperate with the abutment in the lock position. The resilient strip comprises two spring arms 56, 58, each extending from the distal end 42 in direction to the first part 36 of the spring clip 30 with an increasing cross section to form the lateral edges of the V-shaped opening 52. This spring arms 56, 58 are configured in order to even out the stress in the material when a force is applied on the distal end according to a transverse direction.

Operationally, the spring clip 30 is retained by engagement of an aperture edge 60 of the aperture 50 with the protrusion 32 arranged on the top wall 24 and engagement of an edge 62 of the resilient lip 54 with the abutment 34 of the side wall 26.

To have a cost and an assembly method efficient the spring clip is made of a spring steel sheet metal.

Advantageously, the pressing device 10 can further comprise a plate 70 parallel to the side wall 26 and arranged between the component 16 and the spring clip 30 in the lock position in order to distribute the pressure exerted by the spring clip.

Another object of the invention relates to a method for assembling such a component against such an element thanks to a pressing device as described hereinbefore.

More particularly, a method for pressing a component against an element will now be detailed.

After providing the element having the pressing device comprising the spring clip and the component, the component is positioned against the side wall of the element.

As the first part of the spring clip is pressed against the top wall of the element 12, here the heatsink 14:
- the aperture edge 60 of the aperture 50 is engaged with the protrusion 32 arranged on the top wall 24, then
- the edge 62 of the resilient lip 54 is engaged with the abutment 34 of the side wall 26.

Thus, the first complementary retaining element is engaged with the top retaining element on the top wall to a position in which the second complementary retaining element cooperates with the side retaining element and the spring clip presses the component against the side wall of the element in a lock position.

Advantageously, the spring clip is installed according to a vertical direction, *i.e.* a direction perpendicular to the top wall of the element in order to have one simple assembly method for several components and not conflict with neighbouring components during the assembly.

Thanks to the invention, a pressing device is provided which is reliable, compact and can be easily assembled.

While preferred embodiments of the invention have been described above, it is to be understood that variations and modifications will be apparent to those skilled in the art without departing from the scope of the invention.

## Claims

1. Pressing device (10) of an element (12) for pressing a component (16) against the element, the element (12) comprises a top wall (24) and a side wall (26) extending perpendicular to the top wall, the pressing device (10) comprising a spring clip (30), a top retaining element (32) and a side retaining element (34), wherein the top retaining element and the side retaining element are arranged respectively on the top wall and on the side wall and configured respectively to cooperate with a first and a second complementary retaining elements (44, 46) arranged on the spring clip (30), and wherein the spring clip is configured to exert a force to press the component against the side wall of the element in a lock position when the component is positioned against the element.

2. Pressing device according to claim 1, wherein the spring clip comprises a proximal end (40) and a distal end (42), the first complementary retaining element (44) is arranged on the proximal end and the second complementary retaining element (46) is arranged between the proximal end and the distal end; and wherein the distal end is configured to exert the force on the component when the spring clip presses the component against the side wall of the element.

3. Pressing device according to claim 1 or 2, wherein at least one of the top retaining element (32) and the side retaining element (36) comprises a protrusion extending from the wall comprising the at least one of the top and the side retaining elements and the complementary retaining element (44, 46) configured to cooperate with the at least one of the top and the side retaining elements comprises an aperture (50, 52) configured to cooperate with the protrusion.

4. Pressing device according to any of the preceding claims 1 to 3, wherein the first complementary retaining element (44) at the proximal end (40) of the spring clip comprises a lip (51) and the top retaining element (32) comprises a groove (33) arranged on the top wall (24) and configured to cooperate with the lip (51) at the proximal end of the spring clip.

5. Pressing device according to any of the preceding claims 1 to 4, wherein the second complementary retaining element (46) of the spring clip comprises a resilient lip (54) adapted to cooperate with the side retaining element (34).

6. Pressing device according to any of the preceding claims 1 to 5, wherein the spring clip (30) comprises a first part (36) and a second part (38) on which is arranged respectively the first and the second complementary retaining elements (44, 46), the first part and the second part forming a first angle less than or equal to 90° in a rest position wherein the component is not pressed.

7. Pressing device according to claim 6, wherein:
- the second part (38) forms a resilient strip extending according to a reference plane,
- the side retaining element (34) comprises an abutment extending perpendicular to the side wall (26), and
- the second complementary retaining element (46) comprises an opening (52) having a V-shape configured to form a receptacle for the abutment and a resilient lip (54) extending from the distal end (42) and having a complementary V-Shape, the resilient lip being configured to cooperate with the abutment in the lock position.

8. Pressing device according to any of the preceding claims 1 to 7, wherein the pressing device is for pressing an electronic component (18).

9. Pressing device according to any of the preceding claims 1 to 8, wherein the element (12) comprises a heatsink (14).

10. Pressing device according to any of the preceding claims 1 to 9, further comprising a plate (70) parallel to the side wall and arranged between the component (16) and the spring clip (30) in the lock position.

11. Method for pressing a component against an element comprising a pressing device according to any of the preceding claims 1 to 10, the method comprising the steps of:
- providing the element and the pressing device comprising the spring clip;
- providing the component and positioning the component against the side wall of the element;
- engaging the first complementary retaining element with the top retaining element on the top wall to a position in which the second complementary retaining element cooperates with the side retaining element and the spring clip presses the component against the side wall of the element in a lock position.
